# EUROPEAN PATENT APPLICATION

(11) **EP 4 312 373 A1**
(43) Date of publication of application: **31.01.2024**
(21) Application number: 22186973.8
(22) Date of filing: 26.07.2022
(51) Int. Cl.: H03K 17/96, H01H 9/00, H02G 3/12

(54) **ILLUMINATION-SUPPORTED CONTROL ELEMENT, AND ILLUMINATION-SUPPORTED CONTROL METHOD FOR BUILDING INSTALLATIONS**

(71) Applicant: ABB SCHWEIZ AG, 5400 Baden (CH)
(72) Inventor: ZIERACH, Falk, 58762 Altena (DE); KEMPER, Jürgen, 59425 Unna (DE); WIESE, Michael, 42897 Remscheid (DE); KLOY, Olaf, 42389 Wuppertal (DE); KREUTZBERG, Steffen, 59174 Kamen (DE); DECKER, Jens, 51580 Reichshof (DE)
(74) Representative: Zimmermann & Partner Patentanwälte mbB

(57) **Abstract**

A technique for an illumination-supported control element (200) and a control method (800) for controlling at least one building installation by a user is provided. The control element (100) comprises at least one operating element (10) configured to detect a user input, a logic unit (14) configured to convert the user input to the at least one operating element into a control signal for the at least one building installation, a BUS interface (12) configured to transmit the control signal to a control system of the at least one building installation, a plurality of light-emitting diodes, LEDs (16), and a light guide (18) optically coupled to the plurality of LEDs (16). The logic unit (14) is configured to control each of the plurality of LEDs (16) according to the control signal.

## Description

### TECHNICAL FIELD

The disclosure generally relates to an illumination-supported control element, and an illumination-supported control method for building installations.

### BACKGROUND

Automation of building installations is advancing. In this context, manual control of building installations is increasingly replaced by electronic equivalents. The term building installations, as used herein, refers to installations of interior as well as exterior spaces, such as lightening, air conditioning, heating, (rolling) shutters, blinds, comfort scenes, windows, or gates. Electronic or electro-mechanical control elements are, in some cases, remotely located from the actual building installation they are meant to control. Also, with increasing complexity of control elements, their operation may become more challenging for a user. Thus, feedback of the operating status of the building installation may facilitate a user's experience.

According to the conventional technology, for example, a control element is provided with operating elements. Examples of such control elements include, in some cases, tactile or optical feedback. The optical feedback is, however, often arranged in a way that during operation by a user, the user's hand or finger conceals the optical feedback. Thus, a user must remember the optical feedback before and after operating the control element. Therefore, present invention aims at providing a control element with an optical feedback or signal that is conveniently recognizable by a user at all times. In particular, present invention aims at providing an optical feedback or optical user guide which informs the user about the operating status of a building installation, for instance with specific illumination animations.

### SUMMARY OF THE DISCLOSURE

According to an aspect of the invention, an illumination-supported control element is provided. The illumination-supported control element is configured for controlling at least one building installation by a user. The control element comprises at least one operating element which is configured to detect a user input, and a logic unit configured to convert the user input to the at least one operating element into a control signal for the at least one building installation. The control unit further comprises a BUS interface configured to transmit the control signal to a control system of the at least one building installation. The control unit also has a plurality of light-emitting diodes, LEDs, and a light guide optically coupled to the plurality of LEDs. The logic unit is further configured to convert the control signal into an animation signal to control each of the plurality of LEDs according to the animation signal.

Operation element, as used herein, may refer to an electro-mechanical or electronic actuating device. Examples may include a switch or a predefined input gesture by a user. In some cases, one operation element may be used to control a single building installation, while, in other cases, a single operation element may be used to control a plurality of building installations. Operating element and operation function may be used interchangeably in some cases.

The BUS interface may be adapted to communicate KNX bus. The control system of the building installation may refer, for instance, to a thermostat of a heating, or a motor control of blinds.

In some examples, the interface unit may be realized by the BUS interface. Alternatively, the BUS interface may be integrated into a flush-mounted insert. Alternatively, the control element may comprise a wireless interface, such as a Bluetooth interface, that may serve as the interface unit and/ or for transmitting control signals to the building installations. In that case, the control element may be powered by a flush-mounted insert to which it is connected to.

The dimensions of the control element or the operating element may generally correspond to common frame-bound sizes of operating elements. In particular, the dimensions may correspond to any of 44 mm ^{∗} 44 mm; 54 mm ^{∗} 54 mm; 55 mm ^{∗} 55 mm; or 63 mm ^{∗} 63 mm. Depending on mechanical and/ or electrical requirements, the active surface of the operating element may correspond, for instance, to 46 mm ^{∗} 44 mm for a printed circuit board assembly; or, for instance, to 44 mm ^{∗} 42 mm for a touchpad or touchscreen. The control signal may actuate one or more building installations or a specific function thereof. Examples include a control signal that causes a lamp to be switched on or off; brightness of a lamp to be increased or decreased; or a window to be opened or closed. In some cases, an operation element may cause the control signal to also include a specific time to elapse before actuating a building installation. For example, an operation function may define that, actuating a building installation in 1 minute in response to a user input.

Further features are derivable from the dependent claims.

The logic unit may be further configured to control each of the of LEDs according to external conditions. External conditions may include, for instance, time of day, location of the control element, or type of building installation. For example, the plurality of LEDs of a control element located in an public spaces may be controlled to be always illuminated, while the plurality of LEDs of a control element in an office may only be illuminated during office hours.

In embodiments, the at least one operating element comprises any of an electro-mechanical switch and a touch-operating element. Examples include a pushbutton switch, a rocker switch, a wipe switch, a slider switch, a rotate switch, a gesture switch, and a predefined input gesture by a user. The latter may be realized by means of a touch-operating element, such as a capacitive area sensor, a touchpad or a touchscreen.

In embodiments, the touch-operating element is configured to be parametrized by an operation function. The operation function may be configured to virtually represent an operating element. The touch-operating element may be realized by a capacitive area sensor.

In cases where the illumination-supported control element includes more than one operating element, the types of the operating elements may be mutually different. For instance, a first type of operating element is a rocker switch, while a second type of operating element is a pushbutton switch. In other cases, the types of the operating elements are identical or partially identical. The respective operating element may signify different sizes within the layout of the control element. For instance, a pushbutton switch may be represented by a smaller area than a predefined input gesture by a user. The type may thus also be conditional on the arrangement of each of the operation elements within the control element.

A predefined input gesture by a user, as used herein, refers to an implementation which includes an operation element that is represented by a specific user gesture. The predefined input user gesture may be implemented by a touch-operating element, such as a capacitive area sensor. Those user gestures may include, for instance, tapping the capacitive area sensor with the finger, double tapping the capacitive area sensor with two fingers, sliding two fingers on the capacitive area sensor up and/ or down, pitching on the capacitive area sensor with a user's thumb and pointer finger. The implementation may assign a specific operation function to the respective gesture. For instance, increasing the brightness of a lamp may be assigned the gesture of pitching on the capacitive area sensor with a user's thumb and pointer finger.

In embodiments, the arrangement of the at least one operating element corresponds to a single-fold or multi-fold switch. In embodiments, the multi-fold arrangement may comprise any of the range of two-fold switch to ten-fold switch, in particular a four-fold switch. The multi-fold arrangement may correspond to a matrix layout of the control element with evenly sized operation elements. Alternatively, the multi-fold arrangement may correspond to a layout with unevenly sized operation functions, for instance when different types of operation functions are provided by the parametrization.

In embodiments, a design cover is connected to the control element and is configured to optically represent the parametrized operating element. The design cover may be the control element's outer cover which a user touches. The design cover may be configured in a way to avoid attenuation of the user input

The logic unit may further be configured to control each of the plurality of LEDs according to the operating elements of the control element. This can mean, for instance, that if the control element provides for a single operation element, the plurality of LEDs can be controlled such that only a single LEDs is operated. Otherwise, the plurality of LED may be segmented according to the number of operating elements and controlled in a segmented manner. Alternatively, the plurality of LEDs or a part of the plurality of LEDs is controlled in a concerted manner.

In embodiments, the plurality of the LED may be controlled according the concept of orientation lighting, status lighting, optical operator feedback, or optical animation.

The concept of orientation illumination may represent an adjustable, single-color illumination that is independent of the type and number of the control element, or any control signal. Rather, the brightness of the LEDs can be varied depending on external conditions. As an example, orientation illumination may switch from high brightness to low brightness, or vice versa, at the transition from day to night mode.

The concept of status illumination may be used to visually represent the status or current operation mode of the operation element. This makes it possible, for example, to visualize the switching status of a lamp via different color assignments and/ or brightness directly on the control element. For example, the on state of said lamp may be represented by the color red and the off state by the color green. Depending on how many elements are arranged on the control element, for example 1-fold or 4-fold, several segments of LEDs may be combined. This concept is particularly suitable for operating elements with key switches or rocker switches.

The concept of optical operator feedback may visually indicate that a user input to the operation element has been detected. For instance, if a key switch is arranged at the left-hand side of the control element, and a user input has been detected to the represented key switch, the corresponding LED segments may flash or darken briefly. Afterwards, the LEDs may be controlled according to the concept of orientation illumination or status illumination.

The concept of animation function may visually support an actuated operation element. The animation function may be implemented using the animation signal. Segments of the LEDs may be controlled according to the animation signal. The animation signal may assign any color, brightness, and/or status to the LEDs. The animation signal may control the order, illumination transitions and/ or duration of LEDs to be illuminated.

After completion of an animation, the LEDs may be controlled according to the concept of orientation illumination or status illumination. The animation function may also include elements from the concept of orientation illumination or status illumination.

For instance, in the case of a swipe switch, a swipe gesture that is implemented as a predefined input gesture by a user, a slide switch, or a slide gesture that is implemented as a predefined input gesture by a user, the animation signal may control the four LEDs on one side to be switched on or off in such a way that the current set size (0 - 100%) is visualized in 25% steps according to the four LEDs per side. In case of operation functions that are active longer than the detected touch input by the user, e.g. the movement time of a blind, the animation signal may control the LEDs such that the animation function is repeated until the time needed to achieve the stored function has elapsed.

The arrangement of the rotation switch or a user gesture implemented as such may cover the entire area of the control element. In this specific case, the light guides on both sides are available for visual support of the animation function, for example, for adjusting the setpoint of the room temperature. A counter-clockwise operation may be displayed as a setpoint reduction, e.g. in blue, and a clockwise operation may be displayed as a setpoint increase, e.g. in red. The animation function may serve to implement a running light corresponding to the operating direction. The current level of adjustment may be visualized analogously to the wipe gesture by switching individual LEDs on or off. This concept of animation function may be particularly suitable for wipe, slide or rotate switches. In general, the animation signal controls such an animation function.

The plurality of LEDs may comprise RGB LEDs, enabling the control element to represent a range of optical signals with a single LED.

The illumination-supported control element may as well comprise a printable circuit board assembly (PCBA). The control element may be arranged at a top side of the PCBA, while the plurality of LEDs may be arranged at a second side of the PCBA, the bottom side being opposite of the first side.

The light guide may be laterally arranged at the PCBA. Also, electronics for touch detection may be laterally arranged at the PCBA. The light guide may be optimized for homogeneous light distribution and may be made of translucid plastics which allow for optimal color mixing. The light guide may be elongated. In some embodiments, the light guide is segmented. In other embodiments, the light guide is formed of individual pieces of light guides. A piece of a light guide may be optically coupled to two LEDs. The light guide may be arranged at opposite sides of the PCBA. Alternatively, the light guide may surround the PCBA on all of its four sides.

In embodiments, the illumination-supported control element further comprises a sensor base. The sensor base may be designed to accommodate the printed circuit board at a first side. The sensor base comprises a clamping arrangement at a second side that is configured to fasten the control element on a flush-mounted insert.

The light guide may protrude in a gap between the design cover and the sensor base of the control element.

In embodiments, the design cover comprises at least one recess. The light guide may be arranged in the at least one recess. In addition or alternatively, there may be at least one transparent light window in the design cover. The light guide may be optically coupled to the transparent light window. The recess or the transparent light window may be strip-shaped or elongated. The recess or the transparent light window may be laterally arranged within the design cover. This allows for optimal visual operating feedback that is visible, even when the user's finger or hand covers much of the control element.

According to embodiments, the design cover and the sensor base are connected such that the control element is sealed. The sealing may prevent water or other environmental influences from entering into the control element.

According to an aspect, a switching assembly is provided. The switching assembly comprises above described illumination-supported control element having a plurality of LEDs and a light guide. The switching assembly further has a frame which is configured to accommodate the illumination-supported control element such that a gap between the illumination-supported control element and the frame is configured to be illuminated by the light guide. This allows for optimal visual operating feedback that is visible, even when the user's finger or hand covers much of the control element.

According to an aspect, a control method for controlling at least one building installation is provided. The control method provides for detecting, by the operating element, a user input and converting, by the logic unit, the user input to the at least one operating element into a control signal for the at least one building installation. The control method further provides for controlling, by the logic unit, the plurality of LEDs according to the control signal, wherein the control signal comprises an animation signal and transmitting, by the BUS interface, the control signal to a control system of the at least one building installation.

### BRIEF DESCRIPTION OF THE DRAWINGS

Fig. 1 illustrates a schematic side view of an illumination-supported control element according to an embodiment described herein.
Fig. 2 illustrates a schematic diagram of illumination-supported control element according to an embodiment;
Fig. 3 illustrates a schematic diagram of a first side of a printable circuit board according to embodiments described herein.
Fig. 4 illustrates a schematic diagram of a second side of a printable circuit board according to embodiments described herein
Fig. 5a and 5b illustrate schematic diagrams of a illumination-supported control element according to a further embodiment;
Fig. 6 illustrates a switching assembly according to an embodiment;
Fig. 7 illustrates a schematic diagram of illumination-supported control element according to an embodiment;
Fig. 8 illustrates a schematic diagram of a control method for a control element according to an embodiment.

### DESCRIPTION OF EMBODIMENTS

In the following, embodiments are set forth to describe specific examples presented herein. The person skilled in the art will recognize that one or more other examples and/ or variations of these examples may be practiced without all the specific details outlined below. Also, well known features may not be described in detail so as not to obscure the description of the examples herein. For the ease of illustration, like reference numerals are used in different figures to refer to the same elements or additional instances of the same element. Features illustrated or described as part of one embodiment can be used on or in conjugation with any other embodiment to yield yet a further embodiment.

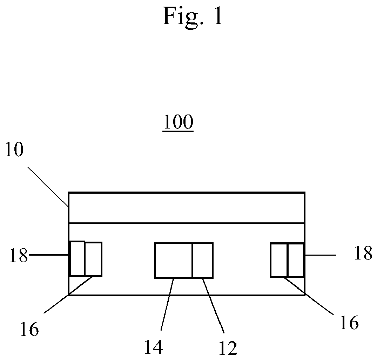

Referring now to the drawings, Fig. 1 presents a side view of an illumination-supported control element 100 for controlling at least one building installation by a user according to an embodiment described herein. The control element 100 has an operating element 10. The operating element10 may span the entire surface of the control element 100. The control element 100 further has a BUS interface 12. The BUS interface unit 12 serves to transmit a control signal to building installations. A logic unit 14 may serve to convert a user input to the one or more operation element into a control signal for at least one building installation. The logic unit 14 may also serve to convert the control signal into an animation signal to control each of the plurality of LEDs according to the animation signal. The control element 100 is further equipped with a plurality of LEDs 16 and a light guide 18 optically coupled to the plurality of LEDs. The logic unit 14 is also configured to control the plurality of LEDs according to the control signal.

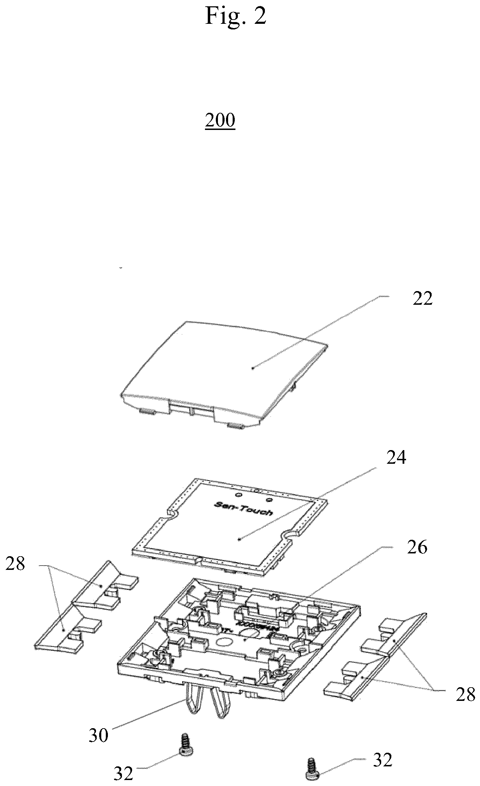

Fig. 2 illustrates a schematic diagram of illumination-supported control element 200 according to a further embodiment. The control element is presented in an exploded manner. The control element 200 may have a design cover 22, which can be arranged at the outer side of the control element 200 and can be in contact with the environment or potential users of the control element 200. The design cover 22 can serve to connect to the printable circuit board, PCBA, 24 which may carry the control element on one side, and a plurality of LED at the other side, the other side facing downward in this Fig. As shown, the operating element may span the entire surface of the PCBA 24 which corresponds to the area of the control element 200.

When assembled, the sensor base 26 can accommodate the PCBA 24, and light guides 28 may be sandwiched between the sensor base 26 and the PCBA 24 such that an edge of the light guides 28 protrudes from the assembled control element 200. Although depicted as four separate light guides 28 that are arranged on opposite sides of the control element 200, the number as well as the arrangement of the light guides 28 may deviate therefrom. An edge of the light guide 28 may surround the assembled control element 200 on all of its four sides, in some examples.

A clamping arrangement 30 can be provided at the side of the sensor base 26 opposite to the side accommodating the PCBA 24. The clamping arrangement 30 can serve to fasten the control element 200 at a flush-mounted insert (not shown) and may serve as a electro-mechanical interface. The control element 200 can be assembled by screws 32 and mounted, in its assembled form, to a flush-mounted insert.

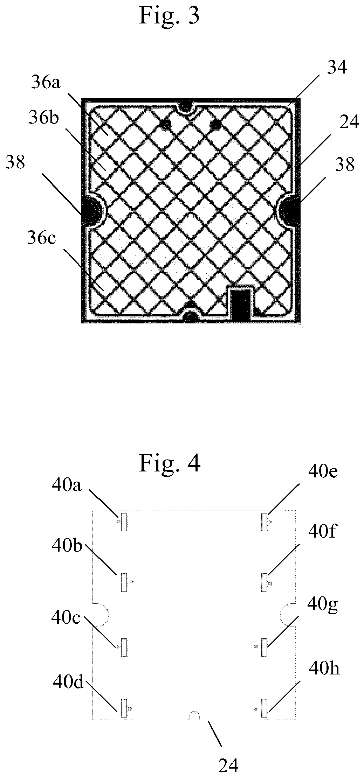

Fig. 3 illustrates a schematic diagram of a first side of the PCBA 24 according to an embodiment. This side of the PCBA 24 can carry the operating element 34. When the control element is in use, the first side of the PCBA 24 may face towards a potential user or the environment. In this Fig., the operating element 34 is realized as a touch-operating element, such as a capacitive area sensor. As such, it may have individual sensing points, here exemplarily referred to as 36a, 36b, 36c. The number of individual sensing points may deviate from the one illustrated. To realize a desired resolution of the operating element 34, the sensing points may be algorithmically varied. Side recesses 38 can serve to assemble the PCBA 24 within the control element. The individual sensing points 36a, 36b, 36c may be grouped together to actuating fields (not shown).

Fig. 4 illustrates a schematic diagram of a second side of a PCBA 24 according to embodiments described herein. When the control element is in use, the second side of the PCBA can face towards a wall or arrangement the control element 300 is fastened to. A plurality of LEDs 40a ... 40h can be disposed at the second side of the PCBA. Each of the plurality of LEDs can be individually controllable. The LEDs may be optically coupled to a light guide (not shown). In some examples, two LEDs can be coupled to one light guide, whereby any other ratio is possible as well.

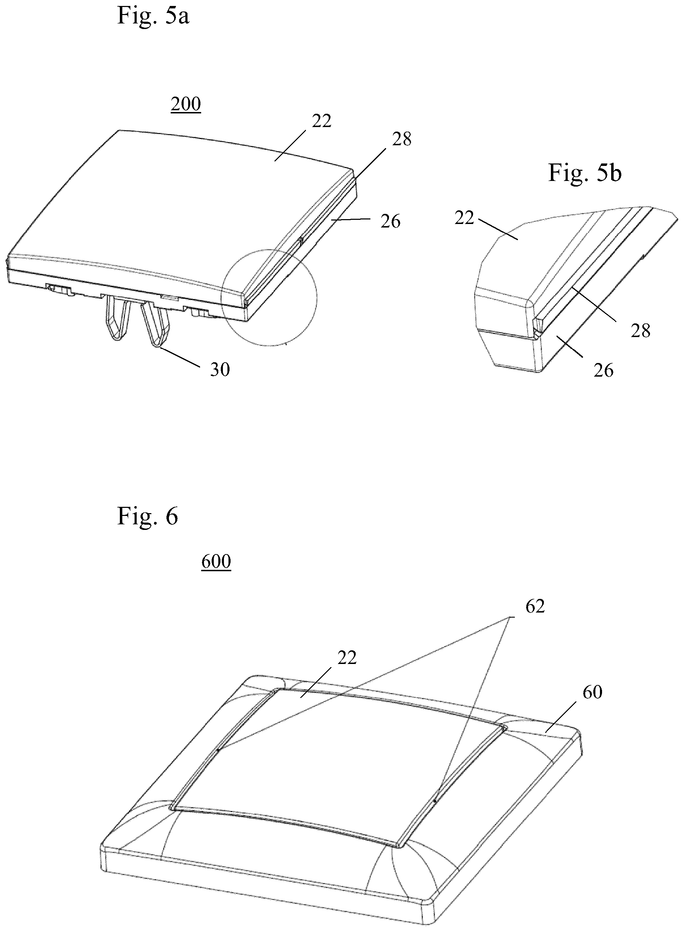

Fig. 5a illustrates a schematic diagram of illumination-supported control element 200 according to a further embodiment. Therein, the control element 200 is depicted in assembled form. In assembled form, the outside elements of the control element 200 may be visible, in particular, the design cover 22, the sensor base 26, and the light guide 28 which is sandwiched between the design cover 22 and the sensor base 26. Also, the clamping arrangement for fastening the control element 200 to a flush-mounted inset is depicted in Fig. 5a. In Fig. 5b, a magnification of the lower right side of the control element 200 is depicted. As can be seen therefrom, the light guide 28 can protrude from the assembled control element 200, the edges of the design cover 22 and the sensor base 26 forming one plane.

Fig. 6 illustrates a switching assembly 600 according to an embodiment. Above-discussed control element 200 with design cover 22 can form part of the switching assembly 600, as well as a frame 60. The frame 60 can accommodate the control element such that the control element's design cover 22 is exposed and may be touched by a user's finger. The switching assembly 600 can provide for an accommodation of the control element which leaves a gap 62 for the light guides to illuminate, and ultimately to reach the user's eye.

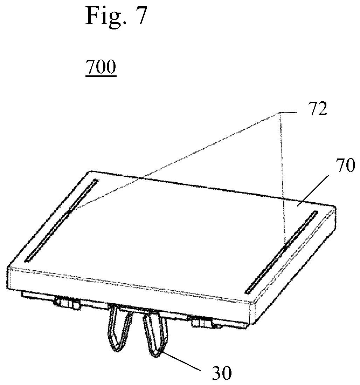

Referring now to Fig.7 which illustrates a schematic diagram of illumination-supported control element 700 of an embodiment in assembled form. The control element 700 can also have above-discussed clamping arrangement for fastening the control element 700 to a flush-mounted inset. The design cover 70 of the control element 700, however, may differ from above-discussed control elements in that two lateral recesses 72 are provided within the design cover 70. The lateral recesses 72 are to be illuminated by the light guides (not shown).

Although not specifically depicted, the skilled person understands that the control element 700 and/ or features thereof may be combined with any other embodiments described herein or features thereof. For instance, the control element 700 may also form part of a switching assembly with a corresponding frame. In this case, no illuminated gap would be provided, as the light of the LEDs is emitted trough the surface of the control element 800.

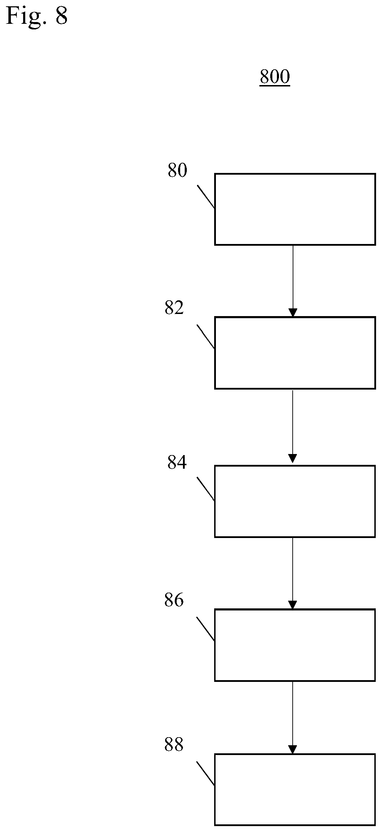

Referring now to Fig. 8 which illustrates a schematic diagram of a control method 800 for a control element according to an embodiment. The control method 800 serves to control at least one building installation. The method 800 provides for detecting (80), by the operating element, a user input. Further, the method 800 provides for converting (82), by the logic unit, the user input to at least one operation function into a control signal for the at least one building installation. In step 84, the control signal is converted into an animation signal to control each of the plurality of LEDs. Within the next step 86, the method provides for controlling, by the logic unit, the plurality of LEDs of the at least one operating function according to the control signal. Lastly, the method provides for transmitting 88, by the BUS interface, the control signal to a control system of the at least one building installation.

Embodiments and/ or features described herein with respect to the control method may be implemented equally within the control element and vice versa.

## Claims

1. An illumination-supported control element for controlling at least one building installation by a user, the control element comprising:
- at least one operating element configured to detect a user input;
- a logic unit configured to convert the user input to the at least one operating element into a control signal for the at least one building installation;
- a BUS interface configured to transmit the control signal to a control system of the at least one building installation;
- a plurality of light-emitting diodes, LEDs;
- a light guide optically coupled to the plurality of LEDs;
wherein the logic unit is further configured to convert the control signal into an animation signal to control each of the plurality of LEDs according to the animation signal.

2. The illumination-supported control element according to the preceding claim, wherein the logic unit is further configured to control each of the plurality of LEDs according to external conditions.

3. The illumination-supported control element according to any of the preceding claims, wherein the at least one the operating element comprises any of:
- an electro-mechanical switch;
- a touch-operating element.

4. The illumination-supported control element according to the preceding claim, wherein the touch-operating element is configured to be parametrized by an operation function, wherein the operating function is configured to virtually represent an operating element.

5. The illumination-supported control element according to any of the preceding claims, wherein the plurality of LEDs comprises RGB LEDs.

6. The illumination-supported control element according to any of the preceding claims, wherein the light guide is segmented according to the number of operating elements.

7. The illumination-supported control element according to any of the preceding claims, wherein the light guide is elongated.

8. The illumination-supported control element according to any of the preceding claims, further comprising a printable circuit board, PCBA, wherein the at least one operating element is arranged at a first side of the PCBA, wherein the plurality of LEDs is arranged at a second side of the PCBA.

9. The illumination-supported control element according to the preceding claim, wherein the light guide is laterally arranged at the PCBA.

10. The illumination-supported control element according to any of the preceding claims, further comprising a sensor base, wherein the sensor base is configured to accommodate the PCBA at a first side, wherein the sensor base comprises a clamping arrangement at a second side, wherein the clamping arrangement is configured to fasten the control element on a flush-mounted insert.

11. The illumination-supported control element according to any of the preceding claims, further comprising a design cover.

12. The illumination-supported control element according to claim 11, wherein the design cover comprises at least one recess, wherein the recess is laterally arranged, wherein the light guide is arranged to illuminate the at least one recess

13. The illumination-supported control element according to claim 11, wherein the light guide protrudes in a gap between the design cover and the sensor base of the control element.

14. A switching assembly, comprising:
- an illumination-supported control element according to the preceding claim;
- a frame configured to accommodate the control element such that a gap between the control element and the frame is configured to be illuminated by the light guide.

15. Control method for controlling at least one building installation by the illumination-supported control element according to any of the preceding claims, the method comprising
- detecting, by the operating element, a user input;
- converting, by the logic unit, the user input to at least one operation function into a control signal for the at least one building installation;
- converting, by the logic unit, the control signal into an animation signal to control each of the plurality of LEDs;
- controlling, by the logic unit, the plurality of LEDs of the at least one operating function according to the animation signal;
- transmitting, by the BUS interface, the control signal to a control system of the at least one building installation.
